# FASCICULE DE BREVET EUROPEEN

(11) **EP 0 543 745 B1**
(45) Date de publication et mention de la délivrance du brevet: **28.01.1998**
(21) Numéro de dépôt: 92420417.5
(22) Date de dépôt: 17.11.1992
(51) Int. Cl.: H01L 29/772, H01L 23/62

(54) **Transistor MOS à zener de protection intégrée**
MOS-Transistor mit integrierter Zener-Schutzdiode
MOS transistor with integrated zener diode protection

(30) Priorité: 21.11.1991 FR 9114753
(43) Date de publication de la demande: 26.05.1993
(73) Titulaire: SGS-THOMSON MICROELECTRONICS S.A., 94250 Gentilly (FR)
(72) Inventeur: Jimenez, Jean, F-38500 Voiron (FR)
(74) Mandataire: de Beaumont, Michel

(56) Documents cités:
- US-A- 5 008 723
- PATENT ABSTRACTS OF JAPAN vol. 8, no. 261 (E-281)(1698) 30 Novembre 1984 & JP-A-59 132 673
- PATENT ABSTRACTS OF JAPAN vol. 9, no. 136 (E-320)(1859) 12 Juin 1985 & JP-A-60 020 560
- ELECTRICAL OVERSTRESS / ELECTROSTATIC DISCHARGE SYMPOSIUM PROCEEDINGS 1984, PHILADELPHIA, PA, USA pages 202 - 209 LIN CHONG MING ET AL. 'A CMOS VLSI ESD INPUT PROTCTION DEVICE, DIFIDW'

## Description

La présente invention concerne le domaine des transistors MOS et plus particulièrement la protection de transistors MOS de sortie de circuit intégré contre des surtensions, par exemple des impulsions électrostatiques.

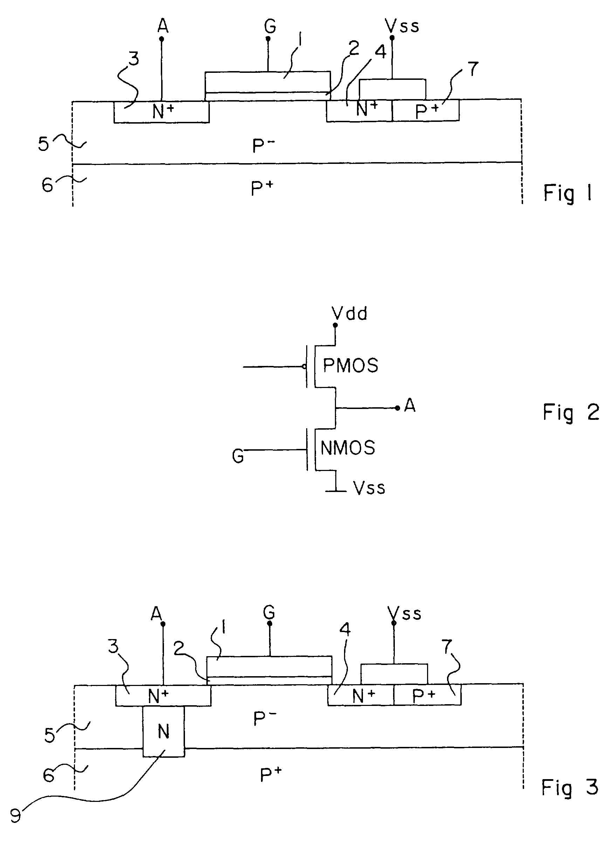

La figure 1 représente en vue en coupe un exemple de structure classique de transistor MOS à canal N de circuit intégré fortement schématisée (voir par exemple JP-A-59/132 673). Ce transistor MOS comprend une région conductrice de grille 1 sur une couche isolante de grille 2. De part et d'autre de la région de grille sont formées respectivement une région de drain 3 de type N⁺ et une région de source 4 de type N⁺. Ces régions sont formées dans une région, une couche ou un caisson 5 de type P faiblement dopé lui-même formé sur une couche ou un substrat 6 de type P fortement dopé. Pour assurer le fonctionnement du transistor MOS, les régions 5 et 6 sont polarisées à un potentiel de référence et il existe une région 7 de type P fortement dopée de prise de contact avec la région 5.

La figure 2 illustre un étage de sortie de circuit intégré MOS, de type CMOS (MOS complémentaire). Cet étage comprend un transistor MOS de type N (NMOS) dont la source est reliée à un potentiel bas ou potentiel de référence Vss en série avec un transistor MOS à canal P, PMOS, dont la source est reliée à un potentiel haut Vdd. Le drain commun des transistors NMOS et PMOS constitue la sortie A. Ainsi, la sortie est à haut niveau quand le transistor PMOS est passant et à bas niveau quand le transistor NMOS est passant.

Quand on utilise le transistor MOS à canal N de la figure 1 en tant que transistor NMOS de la figure 2, sa région de drain 3 est reliée à la sortie A et ses régions de source 4 et de reprise de contact de substrat 7 sont reliées ensemble à la tension basse Vss. On désigne par G la borne de grille de ce transistor NMOS.

Par ailleurs, un transistor MOS contient un transistor bipolaire parasite dont le collecteur correspond à la région de drain 3, l'émetteur à la région de source 4 et la base à la région 5. Du fait de la liaison résistive existant entre ses régions de base et d'émetteur, ce transistor peut rentrer en avalanche quand le courant dans la région 5 devient important, par exemple par suite d'une surtension provenant d'une décharge électrostatique provenant de la borne d'alimentation Vdd ou de la borne de sortie A. Cette mise en avalanche peut, s'il n'existe aucune limitation du courant, se traduire par une destruction du composant résultant soit d'une destruction de l'isolant de grille soit d'un perçage de la jonction de drain lié à une migration du revêtement (non représenté) de métallisation de ce drain.

On a donc été amené à prévoir divers circuits de protection pour éviter ce problème qui peut aussi être résolu en utilisant des structures de type silicium sur isolant telles que décrites dans US-A-5 008 723. La présente invention propose de réaliser oette protection par une structure intégrée simple ne compliquant pas le procédé de fabrication du transistor NMOS.

Pour atteindre cet objet, la présente invention prévoit un transistor MOS formé dans une première région d'un premier type de conductivité à faible niveau de dopage recouvrant une deuxième région du premier type de conductivité à plus fort niveau de dopage comprenant une région de drain du deuxième type de conductivité, une région de source du deuxième type de conductivité et une région de prise de contact avec la première région, les régions de drain, de source et de reprise de contact étant formées à la surface de la première région, la région de source et la région de reprise de contact étant connectées. Ce transistor comprend une troisième région du deuxième type de conductivité à fort niveau de dopage s'étendant à partir d'une partie superficielle de la première région en contact avec la région de drain jusqu'à la deuxième région.

Selon un mode de réalisation de la présente invention, le premier type de conductivité est le type P.

Selon un mode de réalisation de la présente invention, le transistor MOS constitue la sortie d'un circuit MOS.

Ces objets, caractéristiques et avantages ainsi que d'autres de la présente invention seront exposés en détail dans la description suivante de modes de réalisation particuliers faite en relation avec les figures jointes parmi lesquelles :
les figures 1 et 2 décrites précédemment étaient destinées à illustrer l'état de la technique et le problème posé ;
La figure 3 représente une vue en coupe très schématique d'un transistor NMOS selon présente invention.

Comme cela est usuel dans les représentations de composants semiconducteurs, les figures 1 et 3 sont fortement schématiques et les épaisseurs et dimensions relatives des diverses couches et régions ne sont pas tracées à l'échelle.

On retrouve en figure 3 les éléments de la figure 1 désignés par les mêmes références numériques. Selon l'invention, il est prévu entre la région de drain 3 et la couche P⁺ 6 une région 9 de type N fortement dopée, de sorte que l'interface entre cette région 9 et la région 6 forme une diode zener de tension de claquage choisie, supérieure à la tension Vdd, par exemple de l'ordre de 12 volts.

Ainsi, en présence d'une surtension sur la borne A, le claquage de cette diode zener s'effectue loin de la surface d'où il résulte que les porteurs générés par l'avalanche ont peu de chance d'être attirés par la grille (les électrons retournent au drain et les trous au substrat). Par ailleurs, cette diffusion supplémentaire N⁺ étant relativement profonde, par exemple de l'ordre de plusieurs micromètres dans des réalisations classiques, la probabilité de destruction de la jonction par le métal la contactant est extrêmement faible.

Etant donné que la présente invention est destinée à être utilisée dans le cadre de transistors NMOS constituant un étage de sortie comme cela est représenté en figure 2 et que ces transistors ont une surface relativement importante, on aura une place suffisante pour former cette région N profonde, par exemple par diffusion. La surface de jonction entre la région 9 de type N et la région 6 de type P pourra être choisie par l'homme de l'art pour être suffisante pour évacuer rapidement les charges résultant d'une surtension mais sans être excessive pour éviter d'augmenter indûment la capacité drain-substrat du transistor MOS. En effet, pour une même surface de jonction, une jonction N⁺P a une plus grande capacité qu'une jonction N⁺P⁻.

On notera que, dans le cadre d'un circuit intégré complexe du type BICMOS comprenant des composants bipolaires et des zones MOS, la réalisation d'une structure selon la présente invention n'impliquera pas d'étapes supplémentaires de fabrication. En effet, on trouve généralement dans la partie bipolaire du circuit, notamment en relation avec les transistors NPN verticaux de telles diffusions profondes de type N⁺ destinées à assurer un contact avec une couche enterrée de collecteur de type N⁺ au fond d'un caisson N. Cette diffusion N⁺ correspond également à un anneau de garde autour des divers caissons N.

Bien entendu, la présente invention est susceptible de nombreuses variantes et modifications. En particulier, le transistor MOS a été représenté de façon particulièrement élémentaire et les divers perfectionnements généralement apportés aux structures de transistors MOS pourront être adaptés à la présente invention. De plus, la présente invention a été décrite dans le cadre d'un transistor NMOS. Elle pourra s'appliquer de même à des transistors PMOS en inversant tous les types de polarité précédemment décrits.

## Revendications

1. Transistor MOS formé dans une première région (5) d'un premier type de conductivité à faible niveau de dopage recouvrant une deuxième région formant substrat (6) du premier type de conductivité à plus fort niveau de dopage, comprenant une région de drain (3) du deuxième type de conductivité, une région de source (4) du deuxième type de conductivité et une région de prise de contact (7) avec la première région, les régions de drain, de source et de reprise de contact étant formées à la surface de la première région, la région de source et la région de reprise de contact étant connectées,
caractérisé en ce qu'il comprend une troisième région (9) du deuxième type de conductivité à fort niveau de dopage s'étendant à partir d'une partie superficielle de la première région en contact avec la région de drain jusqu'à la deuxième région substrat, d'où il résulte qu'une jonction Zener est formée entre le fond de la troisième région (9) et la deuxième région (6).

2. Transistor MOS selon la revendication 1, caractérisé en ce que le premier type de conductivité est le type P.

3. Utilisation du transistor MOS selon la revendication 1 en tant que transistor de sortie d'un circuit MOS.

## Claims

1. A MOS transistor formed in a first low doped region (5) of a first conductivity type coating a second more highly doped region forming a substrate (6) of the first conductivity type comprising a drain region (3) of the second conductivity type, a source region (4) of the second conductivity type, and a region (7) contacting the first region, said drain, source and contacting regions being formed at the surface of said first region, the source and contacting regions being interconnected,
characterized in that it comprises a third highly doped region (9) of the second conductivity type extending from a surface portion of said first region in contact with said drain region to the second substrate region, whereby a zener junction is formed between the bottom of the third region (9) and the second region (6).

2. A MOS transistor according to claim 1, characterized in that the first conductivity type is P-type.

3. Use of the MOS transistor according to claim 1 as an output transistor of a MOS circuit.

## Patentansprüche

1. In einem ersten Bereich (5) eines ersten Leitfähigkeitstyps mit niedrigem Dotierungsgrad, welcher einen ein Substrat (6) bildenden zweiten Bereich des ersten Leitfähigkeitstyps mit höherem Dotierungsgrad bedeckt, hergestellter MOS-Transistor, welcher einen Drain-Bereich (3) vom zweiten Leitfähigkeitstyp, einen Source-Bereich (4) vom zweiten Leitfähigkeitstyp und einen Bereich (7) zur Kontaktgabe mit dem ersten Bereich aufweist, wobei der Drain-Bereich, der Source-Bereich und der Kontaktierungsbereich an der Oberfläche des ersten Bereichs gebildet sind und der Source-Bereich und der Kontaktierungsbereich miteinander verbunden sind,
dadurch gekennzeichnet, daß der Transistor einen dritten Bereich (9) vom zweiten Leitfähigkeitstyp mit hohem Dotierungsgrad umfaßt, welcher sich von einem mit dem Drain-Bereich in Kontakt stehenden Oberflächenteil des ersten Bereichs bis zu dem zweiten oder Substratbereich erstreckt, derart, daß ein Zener-Übergang zwischen dem Boden des dritten Bereichs (9) und dem zweiten Bereich (6) gebildet wird.

2. MOS-Transistor nach Anspruch 1,
dadurch gekennzeichnet, daß der erste Leitfähigkeitstyp der P-Leitfähigkeitstyp ist.

3. Anwendung des MOS-Transistors nach Anspruch 1 als Ausgangstransistor einer MOS-Schaltung.
